# EUROPÄISCHE PATENTSCHRIFT

(11) **EP 4 252 013 B1**
(45) Veröffentlichungstag und Bekanntmachung des Hinweises auf die Patenterteilung: **31.12.2025**
(21) Anmeldenummer: 21805479.9
(22) Anmeldetag: 02.11.2021
(51) Int. Cl.: G01R 27/02, B60L 3/00, G01R 27/26, G01R 31/14, G01R 31/36, G01R 31/00, G01R 31/40, G01R 31/52

(54) **VERFAHREN ZUM BESTIMMEN ZUMINDEST EINES AKTUELLEN KAPAZITÄTSWERTS EINER Y-KAPAZITÄT EINES HOCHVOLT-BORDNETZES, SOWIE ELEKTRONISCHE RECHENEINRICHTUNG**
METHOD FOR DETERMINING AT LEAST A CURRENT VALUE OF CAPACITANCE OF A Y-CAPACITANCE IN A HIGH TENSION ON BOARD NETWORK AND ELECTRONIC PROCESSING UNIT
MÉTHODE DE DÉTERMINATION D'AU MOINS UNE VALEUR ACTUELLE DE LA CAPACITÉ D'UNE Y-CAPACITÉ DANS UN RÉSEAU EMBARQUÉ HAUTE TENSION ET UNITÉ DE TRAITEMENT ÉLECTRONIQUE

(30) Priorität: 27.11.2020 DE 102020007243
(43) Veröffentlichungstag der Anmeldung: 04.10.2023
(73) Patentinhaber: Mercedes-Benz Group AG, 70372 Stuttgart (DE)
(72) Erfinder: AURAND, Tobias, 71640 Ludwigsburg (DE); ZIMMER, Markus, 70771 Leinfelden-Echterdingen (DE)
(74) Vertreter: Novagraaf Group
(86) Internationale Anmeldenummer: PCT/EP2021/080402
(87) Internationale Veröffentlichungsnummer: WO 2022/111952

(56) Entgegenhaltungen:
- DE-A1- 102016 005 732
- DE-A1- 102019 202 892
- DE-A1- 102020 003 878
- JP-A- 2006 343 267
- US-A1- 2017 016 951

## Beschreibung

Die Erfindung betrifft ein Verfahren zum Bestimmen zumindest eines aktuellen Kapazitätswerts einer Y-Kapazität eines Hochvolt-Bordnetzes für ein zumindest teilweise elektrisch betriebenes Kraftfahrzeug mittels einer elektronischen Recheneinrichtung. Ferner betrifft die Erfindung ein elektrisches Bordnetz.

Aus dem Stand der Technik ist bereits bekannt, dass der Grenzwert aller Kapazitäten in einem elektrischen Bordnetz eines zumindest teilweise elektrisch betriebenen Kraftfahrzeug zwischen den elektrischen Potenzialen HV+ und HV- sowie einer jeweiligen Fahrzeugmasse in einem HV-Fahrzeugsystem, im technischen Sprachgebrauch Y-Kapazität (C_{Y}) genannt, eine zulassungsrelevante Größe darstellt darstellt, die beim Herstellen beziehungsweise beim Bestimmen des Systems produziert werden muss. Dieser Wert ist limitiert, da sich diese Kapazität bei gleichzeitigem Berühren eines HV-Potenzials und des Fahrzeugs über dem Körper entlädt und gegebenenfalls somit zu einer gefährlichen Körperdurchströmung führen könnte. Da diese Kapazitäten einerseits durch parasitäre Effekte entstehen sowie andererseits in Form von Bauteilen zur Entstörung von Komponenten in deren elektronische Schaltungen eingebaut werden und zudem Einfluss auf die Isolationskoordination haben, ist es wichtig, den tatsächlichen Wert dieser Y-Kapazität möglichst gut zu kennen.

Die DE 10 2016 006 642 A1 betrifft eine Hochvolt-Batterie für ein Kraftfahrzeug, umfassend ein elektrisch leitfähiges Batteriegehäuse, einen Batteriezellstapel, der zur Bereitstellung einer Hochvolt-Spannung aus einer Vielzahl von elektrisch in Serie geschalteten Batteriezellen gebildet ist, welche innerhalb des Batteriegehäuses angeordnet sind, wobei der Batteriezellstapel zwischen eine Hochvolt-Plusleitung, welche mit dem Pluspol des Batteriezellstapels elektrisch leitend verbunden ist, und eine Hochvolt-Minusleitung, welche mit dem Minuspol des Batteriezellstapels elektrisch leitend verbunden ist, geschaltet ist, und ein Isolationsmessgerät, welches dazu ausgelegt ist, in Abhängigkeit von einem Isolationswiderstand zwischen dem Batteriezellstapel und dem Batteriegehäuse einen Isolationsfehler zu ermitteln. Eine Lokalisierungsvorrichtung ist dazu ausgelegt, in Abhängigkeit von einer zwischen der Hochvolt-Plusleitung und dem Batteriegehäuse anliegenden ersten Spannung und/oder von einer zwischen der Hochvolt-Minusleitung und dem Batteriegehäuse anliegenden zweiten Spannung den ermittelten Isolationsfehler in dem Batteriezellstapel zu lokalisieren. Überdies betrifft die Erfindung ein entsprechendes Verfahren.

Gemäß der DE 10 2010 054 413 A1 wird ein Verfahren zum Lokalisieren eines Isolationsfehlers in einem System bereitgestellt, das einen DC-Abschnitt mit einer High Side (HV+) und einer Low Side (HV-) und einen AC-Abschnitt einschließlich eines Wechselrichters mit mindestens einer Reihenschaltung aus zwei Leistungsschaltern, die zwischen der High Side (HS-Seite) und der Low Side (LS-Seite) geschaltet ist, aufweist. Der DC-Abschnitt wird mit einer Gleichspannung einer Gleichspannungsquelle versorgt. Es erfolgt ein Durchschalten des unmittelbar an der HS-Seite anliegenden Leistungsschalters entsprechend einem HS-Durchschaltzustand, ein Durchschalten des unmittelbar an der LS-Seite anliegenden Leistungsschalters entsprechend einem LS-Durchschaltzustand, einem Messen jeweils einer HS-Isolationsspannung zwischen der HS-Seite und einer Masse sowie einer LS-Isolationsspannung zwischen der LS-Seite und der Masse in jedem der beiden Durchschaltzustände und schließlich ein Ermitteln auf der Basis der Messergebnisse, ob ein Isolationsfehler in dem DC-Abschnitt oder AC-Abschnitt vorliegt.

In der DE 10 2016 214 458 A1 ist eine Vorrichtung und ein Verfahren zum Erfassen eines dielektrischen Durchschlags in einem umweltfreundlichen Fahrzeug vorgestellt. Die Vorrichtung enthält eine Messeinrichtung, die zum Messen von Widerstandswerten von Isolationswiderständen konfiguriert ist, die über eine Hochspannungsbatterie angeordnet sind, und eine Steuerung, die zum Messen einer an den Isolationswiderstand angelegten Spannung unter Verwendung der Messeinrichtung und Analysieren eines Musters der gemessenen Spannung konfiguriert ist, um einen Abschnitt des dielektrischen Durchschlags zu erfassen.

Die DE 10 2018 002 926 A1 betrifft ein elektrisches Bordnetz für ein Kraftfahrzeug, mit wenigstens einer ersten und einer zweiten elektrischen Potentialleitung, wobei das Bordnetz ausgebildet ist, in einem bestimmungsgemäßen Betrieb zwischen den Potentialleitungen mit einer elektrischen Gleichspannung beaufschlagt zu werden, wobei das Bordnetz wenigstens einen Y-Kondensator aufweist, der mit einem ersten Anschluss mit einer der Potentialleitungen und mit einem zweiten Anschluss mit einem elektrischen Bezugspotential elektrisch gekoppelt ist, wobei ein Schaltelement zum wenigstens einen Y-Kondensator in Reihe geschaltet ist.

Auch die DE 10 2020 003 878 A1 zeigt ein Hochvolt-Bordnetz für ein zumindest teilweise elektrisch betriebenes Kraftfahrzeug mit zumindest einem Hochvolt-Energiespeicher und mit einem energiespeicherexternen Teil. Der Hochvolt-Energiespeicher weist eine Schutzeinrichtung auf, welche zum elektrischen Verbinden des Hochvolt-Energiespeichers mit dem energiespeicherexternen Teil ausgebildet ist, und einem ersten Isolationswächter. Das Hochvolt-Bordnetz weist zudem einen zentralen zweiten Isolationswächter, zumindest für den energiespeicherexternen Teil, auf.

Die JP 2006 343267 A beschreibt eine Vorrichtung zur genauen und einfachen Messung eines Isolationswiderstands und einer elektrostatischen Kapazität eines Gleichstromkreises gegen Masse, einer sogenannten Y-Kapazität. Hierzu kann durch die Vorrichtung ein Gleichstromkreises über einen zusätzlichen Massewiderstand am Pluspol oder am Minuspol geerdet werden. Zwischen den Anschlüssen des Massewiderstands wird ein stabiler Spannungswert am Anschluss des Pluspols beziehungsweise Minuspols gemessen. So können auf Basis der stabilen Spannungswerte die jeweiligen Isolationswiderstände berechnet werden. Anhand einer Übergangsdauer, bis die Spannung zwischen den Anschlüssen des Massewiderstands eine vorgegebene Spannung erreicht hat, kann zusammen mit dem Isolationswiderstandes eine elektrostatische Kapazität bestimmt werden.

Des Weiteren offenbart die US 2017/016951 A1 ein Isolationswiderstandsmessgerät mit dazugehörendem Verfahren, welches in der Lage ist einen Isolationswiderstand trotz parasitärer Kondensatorkomponenten einer Batterie schnell und genau zu berechnen. Hierzu kann durch eine Schaltersteuereinheit über einen ersten und zweiten Schalter einen ersten Prüfwiderstand und einen zweiten Prüfwiderstand zu den Polen einer Batterie zugeschaltet werden und darüber mit einer Spannungsmesseinheit die angelegte Spannung gemessen werden. Durch eine Messung der Spannung in wenigstens drei Zyklen kann daraus ein Konvergenzwert für die Spannung und damit ein Isolationswiderstand bestimmt werden.

Aus der DE 10 2013 216 801 A1 ist ein System und ein Verfahren zum gleichzeitigen Berechnen eines Isolierungswiderstandswerts und einer Y-Kapazität eines Energiespeichersystems bekannt. Hierbei wird ein erstes Signal in das Energiespeichersystem injiziert, wobei dann ein Ausgabesignal aus dem Energiespeichersystems als Reaktion auf das erste Signal aufgezeichnet wird. Aus dem ersten Signal und dem Ausgabesignal wird in einem Verfahren dann ein Wert als Y-Kapazität und ein Wert als Isolierungswiderstand bestimmt.

Aufgabe der vorliegenden Erfindung ist, ein Verfahren sowie ein elektrisches Bordnetz zu schaffen, mittels welchen eine genauere Bestimmung einer Y-Kapazität innerhalb eines elektrischen Bordnetzes realisiert werden kann.

Diese Aufgabe wird durch ein Verfahren sowie durch ein elektrisches Bordnetz gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen zumindest eines aktuellen Kapazitätswerts einer Y-Kapazität eines Hochvolt-Bordnetzes für ein zumindest teilweise elektrisch betriebenes Kraftfahrzeug mittels einer elektronischen Recheneinrichtung, bei welchem mittels einer Schalteinrichtung des Hochvolt-Bordnetzes ein Hochvolt-Energiespeicher des Hochvolt-Bordnetzes mit einem energiespeicherexternen Teil elektrisch gekoppelt wird und bei welchem mittels eines ersten Isolationswächters in einem energiespeicherinternen Teil des Hochvolt-Bordnetzes ein erster Isolationswiderstand in Abhängigkeit eines Kapazitätswert des elektrischen Bordnetzes bestimmt wird.

Es ist vorgesehen, dass mittels zumindest eines zentralen zweiten Isolationswächters ein zweiter Isolationswiderstand des elektrischen Bordnetzes, insbesondere Hochvolt-Bordnetzes bestimmt wird, und der erste Isolationswiderstand mit dem zweiten Isolationswiderstand mittels der elektronischen Recheneinrichtung des elektrischen Bordnetzes verglichen wird und in Abhängigkeit von dem Vergleich der Kapazitätswert zum Bestimmen des ersten Isolationswiderstands des elektrischen Bordnetzes mittels des ersten Isolationswächters derart angepasst wird, dass sich der erste Isolationswiderstand dem zweite Isolationswiderstand angleicht.

Dadurch ist es ermöglicht, dass der erste Isolationswiderstand mittels des ersten Isolationswächter bestimmt werden kann, auch wenn ein aktueller Kapazitätswert des gesamten Bordnetzes nicht bekannt ist und so dass auch der erste Isolationswächter des energiespeicherinternen Teil des Hochvolt-Bordnetzes für eine genaue Bestimmung des Isolationswiderstands im gesamten Bordnetz genutzt werden kann.

Hier sei anzumerken, dass der zweite Isolationswächter zur Bestimmung des Isolationswiderstands im gesamten Bordnetz keine Kenntnis über einen aktuellen Kapazitätswert des Bordnetzes bedarf und die Bestimmung unabhängig davon durchführen kann.

Hingegen ist der erste Isolationswächter des energiespeicherinternen Teils des Hochvolt-Bordnetzes eigentlich dafür ausgelegt den Isolationswiderstand des energiespeicherinternen Teils des Hochvolt-Bordnetzes zu bestimmen und bedarf dafür den aktuellen Kapazitätswert des zu messenden Bordnetzes, was für den energiespeicherinternen Teil des Hochvolt-Bordnetzes bekannt und in der Recheneinrichtung hinterlegt ist. Damit kann der erste Isolationswächter des energiespeicherinternen Teils des Hochvolt-Bordnetzes den Isolationswiderstand des energiespeicherinternen Teils des Hochvolt-Bordnetzes in Abhängigkeit des Kapazitätswert gut bestimmen, aber bedarf zur Bestimmung des Isolationswiderstands im gesamten Bordnetz eigentlich dem Kapazitätswert des gesamten Bordnetzes, welcher meist nicht bekannt ist.

Nun nutzt das Verfahren den Abgleich zwischen dem ersten Isolationswiderstand und dem zweiten Isolationswiderstand mittels der elektronischen Recheneinrichtung des elektrischen Bordnetzes, indem der Kapazitätswert, von dem der erste Isolationswiderstand abhängt variiert wird und solange angepasst wird, bis sich der erste Isolationswiderstand dem zweiten Isolationswiderstand angeglichen hat. Da sich nun die Isolationswiderstände des ersten und zweiten Isolationswächters gleichen, insbesondere identisch sind, kann davon ausgegangen werden, dass der Kapazitätswert, der zur Bestimmung des ersten Isolationswiderstands herangezogen wurde, nun dem aktuellen Kapazitätswert des Bordnetzes entspricht.

Durch den Abgleich der Isolationswiderstände des ersten und zweiten Isolationswächters kann damit indirekt ein Rückschluss und Bestimmung des aktuellen Kapazitätswerts des Bordnetzes erfolgen. Dieser aktuelle Kapazitätswert kann dann in der Recheneinrichtung oder sonstigen Datenspeichervorrichtungen abgespeichert und hinterlegt werden, insbesondere auch als Start-Kapazitätswert zur Isolationswiderstandsbestimmung für das gesamte Bordnetz. Auch andere Funktionen die von Kapazitäten, insbesondere von den Y-Kapazitäten abhängen, können damit auf die aktuell bestimmten Kapazitätswerte zurückgreifen und diese nutzen.

Mit anderen Worten kann mittels des Verfahrens die Y-Kapazität, welche auch das C_{Y}-Wert bezeichnet werden kann, im Hochvolt-System im Kraftfahrzeug näherungsweise beziehungsweise sehr genau bestimmt werden. Die Summe der Y-Kapazitäten ist zulassungsrelevant, und es kann insbesondere beim Einsatz von Fahrzeugaufbauten mit Anschluss an das Hochvolt-System die Konformität des Gesamtsystems überprüft werden. Des Weiteren liefern die einfachen Isolationsmesseinrichtungen präzise Werte, wenn die entsprechenden Y-Kapazitäten bekannt sind. Kommt es nun zum Ausfall beispielsweise des zweiten Isolationswächters im Hochvolt-System, so kann ersatzweise die batterieinterne Isolationsmesseinrichtung, mit anderen Worten der erste Isolationswächter, den weiteren Betrieb des Hochvolt-Systems ermöglichen. So kommt es nicht zu einem Komplettausfall des Kraftfahrzeugs. Die durch die Ersatzeinrichtung ermittelten Isolationswerte sind durch die ermittelten und abgespeicherten C_{Y}-Werte wesentlich genauer, wodurch sich eine erhöhte Sicherheit gegen Fehlwarnung bezüglich eines aufgetretenen Iso-Fehlers ergibt und die entsprechend gesetzlich vorgeschriebenen Auslöseschwellen auch im Fehlerfall eingehalten werden.

Weicht der ermittelte Kapazitätswert beziehungsweise der ermittelte Isolationswiderstand des ersten Isolationswächters von dem zweiten Isolationswächter ab, so kann rekursiv die Berechnung und mit geänderten, im internen Isolationswächter hinterlegten Cy-Werten solange wiederholt werden, bis die beiden Ergebnisse der Messung übereinstimmen.

Ferner kann auch ein verbessertes Schieflasterkennen realisiert werden. Für ein sicheres Schieflasterkennen und ein entsprechendes Behandeln einer solchen Schieflast können entsprechend die notwendigen C_{Y}-Werte jederzeit bekannt sein und sich darüber hinaus dynamisch an Alterungs- und Temperaturprozesse angepasst werden. Da es möglich ist, die C_{Y}-Werte zu bestimmen, kann darauf verzichtet werden für jede Fahrzeugkonfiguration entsprechende Parameter vorzugeben beziehungsweise abzulegen. Auch ein Umbau des Kraftfahrzeugs und damit einhergehende Veränderungen im Hochvolt-System werden direkt kompensiert.

Es wird somit die Verfügbarkeit im Fehlerfall erhöht, was einem Nutzer des Kraftfahrzeugs Zeit und Kosten spart, da dieser das Kraftfahrzeug zumindest bis zur nächsten Werkstatt weiteführen kann und nicht auf ein Abschleppen des Kraftfahrzeugs warten muss.

Insbesondere ist ferner vorgesehen, dass sich innerhalb des Hochvolt-Energiespeichers der erste Isolationswächter befindet, der in der Lage ist, den Isolationswiderstand des Hochvolt-Energiespeichers vor dem Zuschalten zu bestimmen. Parallel dazu misst der zweite Isolationswächter in einer anderen Komponente den Isolationswiderstand des restlichen Hochvolt-Bordnetzes, um zu vermeiden, dass der elektrische Energiespeicher oder beispielsweise auch eine Brennstoffzelle auf das Hochvolt-Bordnetz aufgeschaltet wird, welches potenziell Probleme in der Isolation aufweist. Kommt es nun zu einem Ausfall des externen zentralen zweiten Isolationswächters, ist der Isolationswert des restlichen Hochvolt-Bordnetzes nicht bekannt, und es müsste aufgrund der Zulassungsrelevanz dieses Werts ein Fehler angenommen und der Betrieb des Fahrzeugs eventuell unterbunden werden, was einen Liegenbleiber verursachen würde. Es ist nun zusätzlich vorgesehen, dass beim Ausfall des zweiten Isolationswächters der erste Isolationswächter, welcher in seiner Ausgestaltung insbesondere funktionsreduziert ist gegenüber dem zweiten Isolationswächter, die Bestimmung des Isolationswerts übernimmt. Hierzu bedarf der erste Isolationswächter aber dem Kapazitätswert des Bereichs des Bordnetzes, für welchen dieser den Isolationswiderstand bestimmen soll. Da in Zeiten eines noch funktionalen zweiten Isolationswächter über den Abgleich des ersten zum zweiten Isolationswiderstand aber eine Bestimmung des Kapazitätswertes ermöglicht war und zur aktuellen Nutzung hinterlegt wurde, kann nun damit der erste Isolationswächter mit dem hinterlegten Kapazitätswert eine Isolationswiderstandsbestimmung für das Bordnetz, insbesondere gesamte Bordnetz übernehmen. Somit kann bei Ausfall des zweiten Isolationswächters ein Notbetrieb des Kraftfahrzeugs ermöglicht werden. Durch die Bestimmung des Y-Kapazitätswerts kann die Ausfallwahrscheinlichkeit noch weiter reduziert werden.

Da je nach Zuschaltung von Teilen des Bordnetzes auch unterschiedliche Konfigurationen möglich sind, die alle unterschiedliche Kapazitätswerte aufweisen können, können auch mehrere Kapazitätswerte bestimmt und hinterlegt werden, so dass zu jeder möglichen Konfiguration des Bordnetzes, je nach Zuschaltung von Teilbereichen des Bordnetzes, auch ein eigener Kapazitätswert hinterlegt ist und bei einem Betriebszustand der jeweiligen Konfiguration auch wieder abgerufen und zur Bestimmung des ersten Isolationswiderstand mittels des ersten Isolationswächters genutzt werden kann.

Insbesondere nutzt somit die Erfindung die Tatsache, dass der erste Isolationswächter besser funktionieren kann, je genauer die Y-Kapazität an den jeweiligen Hochvolt-Potenzialen bekannt ist. Sollte es nun zum Ausfall des zweiten Isolationswächters kommen, so kann durch die zuvorige Bestimmung der Y-Kapazität ein zuverlässiger weiterer Betrieb mit dem ersten Isolationswächter realisiert sein.

Gemäß einer vorteilhaften Ausgestaltungsform wird ein Start-Kapazitätswert für den Kapazitätswert als abgespeicherter Kapazitätswert in einer Speichereinrichtung der elektronischen Recheneinrichtung vorgegeben. Beispielsweise kann der Start-Kapazitätswert bei der Erzeugung des elektrischen Bordnetzes bestimmt und in der Speichereinrichtung hinterlegt werden. Durch entsprechende Alterungen innerhalb des elektrischen Bordnetzes kann es nun zu einer Abweichung des Start-Kapazitätswerts kommen. Durch diese Abweichung wiederum kann es zu einer unterschiedlichen Bestimmung eines Isolationswiderstands kommen. Erfindungsgemäß ist nun vorgesehen, dass der Start-Kapazitätswert durch den aktuellen Kapazitätswert ersetzt oder ergänzt wird. Es kann vorteilhaft sei, den ursprünglichen Start-Kapazitätswert im Speicher zu belassen um einen Abgleich des aktuellen Kapazitätswertes damit durchzuführen. Auch kann wie schon beschrieben der aktuell bestimmte Kapazitätswert zu einer anderen Konfiguration des Bordnetzes und damit ein anderer Kapazitätswert sein. Vorteilhaft kann auch eine Historie über die bestimmten und abgespeicherten Kapazitätswerte erstellt werden, anhand der unter anderem Veränderungen und Alterungen des Bordnetzes oder von Bereiche des Bordnetzes nachvollzogen und eventuell auch prognostiziert werden kann.

Weiterhin vorteilhaft ist, wenn der Start-Kapazitätswert bei der Herstellung des Kraftfahrzeugs vorgegeben wird. Insbesondere können entsprechende Messungen am Kraftfahrzeug durchgeführt werden und die entsprechenden Start-Kapazitätswerte, welche ebenfalls Y-Kapazitätswerten entsprechen, berücksichtigt werden. Diese können beispielsweise dann in der Speichereinrichtung abgespeichert werden und für den zukünftigen Gebrauch für die elektronische Recheneinrichtung bereitgestellt werden.

Ferner hat es sich als vorteilhaft erwiesen, wenn zyklisch der erste Isolationswiderstand mit dem zweiten Isolationswiderstand verglichen wird und eine Anpassung des aktuellen Kapazitätswerts durchgeführt wird. Insbesondere werden entsprechende Messergebnisse des ersten Isolationswächters und des zweiten Isolationswächters zyklisch miteinander verglichen, wobei dies insbesondere während des Betriebs des Hochvolt-Bordnetzes durchgeführt wird. Es wird somit insbesondere zwischen dem ersten Isolationswächter und dem zweiten Isolationswächter umgeschaltet. Sind die Werte über mehrere Messungen hinweg hinreichend stabil, so kann der Wert des ersten Isolationswächters mit dem Wert des zweiten Isolationswächters verglichen werden. Stimmen beide Isolationswiderstände nahezu, insbesondere genau, überein, so entspricht der Kapazitätswert im Wesentlichen dem aktuellen Kapazitätswert und der Kapazitätswert wird als aktuellen Kapazitätswert übernommen, wobei dieser insbesondere annähernd dem tatsächlichen Wert der Summe der entsprechenden Y-Kapazitäten entspricht.

Weiterhin vorteilhaft ist, wenn zum Bestimmen des aktuellen Kapazitätswerts der erste Kapazitätswert iterativ angepasst wird. Mit anderen Worten, entspricht das Verfahren im übertragenen Sinne einem Abgleich einer analogen Messbrücke, bei dem man ebenfalls unbekannte Werte durch Vergleich mit bekannten Werten ermittelt. Es wird solange iterativ der Kapazitätswert angepasst, bis der Wert des ersten Isolationswiderstands dem gemessenen Wert des zweiten Isolationswiderstands entspricht, der mittels des zweiten Isolationswächters ohne Kenntnis einer Kapazität bestimmt wurde. Somit kann ein einfaches und dennoch zuverlässiges Verfahren bereitgestellt werden.

In einer weiteren vorteilhaften Ausgestaltungsform wird der aktuelle Kapazitätswert für eine zukünftige Auswertung einer Speichereinrichtung der elektronischen Recheneinrichtung abgespeichert. Mit anderen Worten wird der bei dem Verfahren ermittelte aktuelle Kapazitätswert abgespeichert. Bei zukünftigen Messungen kann dann der aktuell abgespeicherte Kapazitätswert berücksichtigt werden. Es kann dann beispielsweise vorgesehen sein, dass der aktuell ermittelte Kapazitätswert für die zukünftige Überprüfung herangezogen wird, wobei dann wiederum der Vergleich und Abgleich zwischen den Isolationswiderständen des ersten und zweiten Isolationswächters durchgeführt wird.

Ebenfalls ist es vorteilhaft, wenn in Abhängigkeit von dem bestimmten aktuellen Kapazitätswert der aktuelle Isolationswiderstand des elektrischen Bordnetzes mittels des ersten Isolationswächters bestimmt wird. Beispielsweise kann eine Alterung von Isolationen innerhalb des Kraftfahrzeugs bestimmt werden. Es können dann entsprechende Warnhinweise für einen Nutzer des Kraftfahrzeugs herausgegeben werden, eine bestimmte Komponente des Kraftfahrzeugs beziehungsweise deren Isolation, defekt ist, so dass dieser beispielsweise frühzeitig eine Werkstatt aufsuchen kann, ohne beispielsweise einen Liegenbleiber zu erzeugen.

Gemäß einer weiteren vorteilhaften Ausgestaltungsform wird nach einer Anpassung des aktuellen Kapazitätswerts eine neue Bestimmung des aktuellen Kapazitätswerts durchgeführt und mit dem angepassten aktuellen Kapazitätswert verglichen. Dadurch kann eine Verifizierung des ermittelten Y-Kapazitätswerts für den ersten Isolationswächter durchgeführt werden. Somit kann verifiziert werden, ob der aktuell ermittelte Kapazitätswert auch dem tatsächlichen Kapazitätswert entspricht.

Zusätzlich kann vorgesehen sein, da im Allgemeinen mehr als ein elektrischer Energiespeicher im Kraftfahrzeug verbaut ist, dass mit diesem erfindungsgemäßen Verfahren auch die übrigen ersten Isolationswächter der jeweiligen Energiespeicher die C_{Y}-Werte ermitteln und dass dann beispielsweise die elektronische Recheneinrichtung einen Mittelwert über alle ermittelten Ergebnisse bilden kann. Dieser Mittelwert kann dann als aktueller Kapazitätswert wiederum abgespeichert werden und genutzt werden. Alternativ können die durch das Verfahren anhand der ersten Isolationswächter bestimmten Kapazitäten auch erst verglichen werden, so dass eventuell Ausreißer der Werte oder abwegige Werte bei der Mittelwertbildung unberücksichtigt bleiben. Alternative kann aber bei einer Vielzahl der Werte auch ein Median der Werte als aktueller Kapazitätswert abgespeichert werden.

Ein weiterer Aspekt der Erfindung betrifft ein elektrisches Bordnetz für ein zumindest teilweise elektrisch betriebenes Kraftfahrzeug, mit zumindest einer elektronischen Recheneinrichtung, mit einem elektrischen Hochvolt-Energiespeicher, mit einem ersten Isolationswächter und mit einem zweiten Isolationswächter, wobei das elektrische Bordnetz zum Durchführen eines Verfahrens nach dem vorhergehenden Aspekt ausgebildet ist. Insbesondere wird das Verfahren mittels des elektrischen Bordnetzes durchgeführt.

Ein nochmals weiterer Aspekt der Erfindung betrifft ein Kraftfahrzeug mit einem elektrischen Bordnetz nach dem vorhergehenden Aspekt. Das Kraftfahrzeug ist insbesondere zumindest teilweise elektrisch betrieben. Insbesondere ist das Kraftfahrzeug vollelektrisch betrieben.

Vorteilhafte Ausgestaltungsformen des Verfahrens sind als vorteilhafte Ausgestaltungsformen des elektrischen Bordnetzes sowie des Kraftfahrzeugs anzusehen. Das elektrische Bordnetz sowie das Kraftfahrzeug weisen dazu gegenständliche Merkmale auf, welche eine Durchführung des Verfahrens ermöglichen.

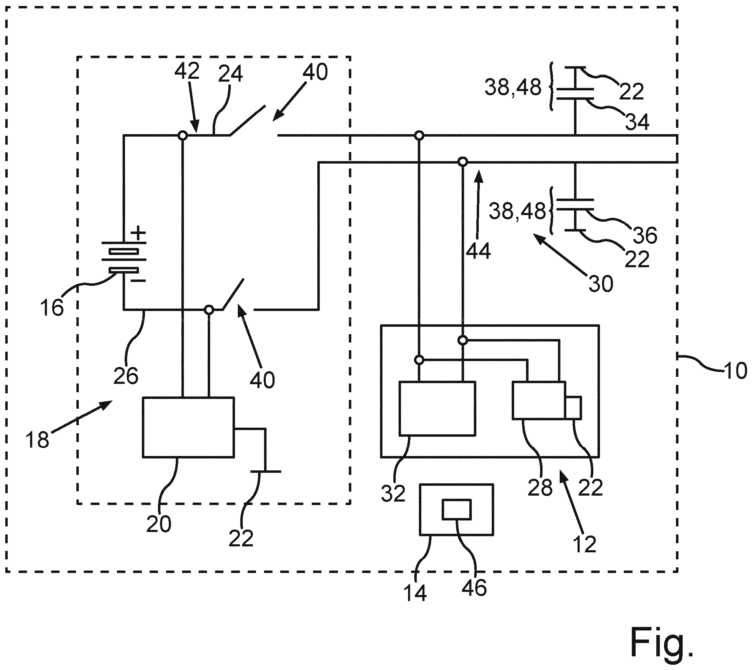

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung genannten und/oder in der einzigen Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Dabei zeigt die einzige Figur ein schematisches Blockschaltbild einer Ausführungsform eines Kraftfahrzeugs mit einer Ausführungsform eines elektrischen Bordnetzes.

In der Figur sind gleiche oder funktionsgleiche Elemente mit den gleichen Bezugszeichen versehen.

Die Figur zeigt rein schematisch eine Ausführungsform eines Kraftfahrzeugs 10 mit einer Ausführungsform eines elektrischen Bordnetzes 12. Das elektrische Bordnetz 12 ist für das zumindest teilweise elektrisch betriebene Kraftfahrzeug 10, insbesondere für das vollelektrisch betriebene Kraftfahrzeug 10, ausgebildet. Bei dem elektrischen Bordnetz 12 handelt es sich insbesondere um ein sogenanntes Hochvolt-Bordnetz. Das elektrische Bordnetz 12 weist zumindest eine elektronische Recheneinrichtung 14 auf. Ferner weist das elektrische Bordnetz 12 zumindest einen Hochvolt-Energiespeicher 16 auf. Es kann vorgesehen sein, dass das elektrische Bordnetz 12 auch eine Vielzahl weiterer Hochvolt-Energiespeicher 16 aufweist. Das elektrische Bordnetz 12 weist ferner in einem energiespeicherinternen Teil 18 einen ersten Isolationswächter 20 auf, welcher mit einer Masse 22 des Kraftfahrzeugs 10 gekoppelt ist. Der erste Isolationswächter 20 ist mit den Hochvolt-Potentialen 24, 26 des Hochvolt-Energiespeichers 16 gekoppelt. Insbesondere ist der erste Isolationswächter mit einem Hochvolt-Plus-Potential 24 und einem Hochvolt-Minus-Potential 26 gekoppelt.

Das elektrische Bordnetz 12 weist ferner einen zweiten Isolationswächter 28 auf, welcher auch als zentraler Isolationswächter bezeichnet werden kann. Der zweite Isolationswächter 28 ist in einem energiespeicherexternen Teil 30 des elektrischen Bordnetzes 12 ausgebildet. Ferner kann vorgesehen sein, dass das elektrische Bordnetz 12 eine Vorladeschaltung 32 zum Vorladen des energiespeicherexternen Teils 30 aufweist.

Der erste Isolationswächter 20 ist gegenüber dem zweiten Isolationswächter 28 insbesondere funktionsreduziert ausgebildet.

In dem Hochvolt-Plus-Pfad 24 kann eine erste Y-Kapazität 34 und dem Hochvolt-Minus-Pfad 26 kann eine zweite Y-Kapazität 36 ausgebildet sein. Bei der ersten Y-Kapazität 34 handelt es sich somit um eine Y-Kapazität, welche zwischen dem Hochvolt-Plus-Pfad 24 und der Masse 22 ausgebildet wird, und bei der zweiten Y-Kapazität 36 handelt es sich um eine Y-Kapazität, welche zwischen dem Hochvolt-Minus-Pfad 26 und der Masse 22 ausgebildet wird.

Beim Verfahren zum Bestimmen des zumindest einen aktuellen Kapazitätswerts 38 einer Y-Kapazität 34, 36 des Hochvolt-Bordnetzes 12 wird das zumindest teilweise elektrisch betriebene Kraftfahrzeug 10 mittels der elektronischen Recheneinrichtung 14 wird mittels einer Schalteinrichtung 40 des Hochvolt-Bordnetzes 12 der Hochvolt-Energiespeicher 16 des Hochvolt-Bordnetzes mit dem energiespeicherexternen Teil 30 elektrisch gekoppelt, und es wird mittels des ersten Isolationswächters 20 in dem energiespeicherinternen Teil 18 des elektrischen Bordnetzes 12 ein erster Isolationswiderstand 42 in Abhängigkeit eines herangezogenen Kapazitätswerts 48 des elektrischen Bordnetzes 12 bestimmt.

Es ist vorgesehen, dass mittels zumindest des zweiten Isolationswächters 28 des energiespeicherexternen Teils 30 ein zweiter Isolationswiderstand 44 des elektrischen Bordnetzes 12 bestimmt wird, und der erste Isolationswiderstand 42 mit dem zweiten Isolationswiderstand 44 mittels der elektronischen Recheneinrichtung 14 des elektrischen Bordnetzes 12 verglichen wird und in Abhängigkeit von dem Vergleich der herangezogene Kapazitätswert 48 zum Bestimmen des ersten Isolationswiderstands 42 des elektrischen Bordnetzes 12 mittels des ersten Isolationswächters 20 derart angepasst wird, dass sich der erste Isolationswiderstand 42 dem zweite Isolationswiderstand 44 angleicht.

Insbesondere kann hierzu vorgesehen sein, dass ein Start-Kapazitätswert für die Bestimmung des ersten Isolationswiderstand 42 als abgespeicherter Kapazitätswert in einer Speichereinrichtung 46 der elektronischen Recheneinrichtung 14 vorgegeben wird. Durch den Abgleich des ersten Isolationswiderstand 42 an den zweiten Isolationswiderstand 44 kann der herangezogene Kapazitätswert 48 als aktueller Kapazitätswert 38 für die Y-Kapazität 34, 36 übernommen werden. Der Start-Kapazitätswert kann insbesondere bei einer Herstellung des Kraftfahrzeugs vorgegeben werden.

Insbesondere ist somit vorgeschlagen, dass zur Bestimmung des ersten Isolationswiderstandes 42 der energiespeicherinterne erste Isolationswächter 20 genutzt werden kann, wozu diesem die Y-Kapazitäten 34, 36 hinreichend bekannt sein müssen. Das heißt, nur wenn der hinterlegte C_{Y}-Wert der Y-Kapazitäten 34, 36, insbesondere eine Summe der Y-Kapazitäten 34, 36, bekannt ist, stimmt auch der gemessene Wert des ersten Isolationswiderstands 42. Es ist nun vorgeschlagen, dass die Ergebnisse des zweiten Isolationswächters 28 als Referenz herangezogen werden, und während des Betriebs des elektrischen Bordnetzes 12 wird zyklisch zwischen dem zentralen und batterieinternen Isolationswächter 20, 28 umgeschaltet. Sind die Werte über mehrere Messungen hinweg hinreichend stabil, so kann der Wert des ersten Isolationswächters 20 mit dem Wert des zweiten Isolationswächters 28 verglichen werden. Stimmen beide überein, so entspricht der im ersten Isolationswächter 20 zu Korrekturzwecken hinterlegte Wert der herangezogenen Kapazität 48 annähernd dem tatsächlichen Wert der Summe Y-Kapazitäten 34, 36.

Weicht der ermittelte Wert des ersten Isolationswiderstand 42 von dem Wert des zweiten Isolationswiderstandes 44, der mittels des zweiten Isolationswächters 28 ermittelten wurde, so kann rekursiv die Bestimmung mit geänderten Kapazitäten 48, die herangezogen werden, insbesondere den C_{Y}-Werten, solange wiederholt werden, bis die beiden Ergebnisse der Isolationswiderstandsmessung übereinstimmen. Eine erneute Messung kann dann zur Bestätigung durchgeführt werden. Das Verfahren entspricht im übertragenen Sinne dem Abgleich einer analogen Messbrücke, bei dem ebenfalls unbekannte Werte durch Vergleich mit bekannten Werten ermittelt werden. Es wird so lange der Wert der herangezogenen Kapazität 48 für den ersten Isolationswächters 20 angepasst, bis der durch diesen gemessene Wert des ersten Isolationswiderstand 42 dem Wert des zweiten Isolationswiderstand 44 entspricht, wobei der zweite Isolationswiderstand 44 anhand des zweiten Isolationswächters 28 insbesondere unabhängig von den C_{Y}-Werten bestimmt wird.

Da im Allgemeinen mehr als ein Hochvolt-Energiespeicher 16 im Kraftfahrzeug 10 verbaut ist, kann mit diesem Verfahren auch über die übrigen Isolationswächter der Hochvolt-Energiespeicher 16 die C_{Y}-Werte ermittelt werden, so dass ein Mittelwert über alle ermittelten Ergebnisse gebildet werden kann.

### Bezugszeichenliste

- 10: Kraftfahrzeug
- 12: elektrisches Bordnetz
- 14: elektronische Recheneinrichtung
- 16: Hochvolt-Energiespeicher
- 18: energiespeicherinterner Teil
- 20: erster Isolationswächter
- 22: Masse
- 24: Hochvolt-Plus-Pfad
- 26: Hochvolt-Minus-Pfad
- 28: zweiter Isolationswächter
- 30: energiespeicherexterner Teil
- 32: Vorladeeinrichtung
- 34: erste Y-Kapazität
- 36: zweite Y-Kapazität
- 38: aktueller Kapazitätswert
- 40: Schalteinrichtung
- 42: erster Isolationswiderstand
- 44: zweiter Isolationswiderstand
- 46: Speichereinrichtung
- 48: herangezogener Kapazitätswert

## Patentansprüche

1. Verfahren zum Bestimmen zumindest eines aktuellen Kapazitätswerts (38) einer Y-Kapazität (34, 36) eines elektrischen Bordnetzes (12) für ein zumindest teilweise elektrisch betriebenes Kraftfahrzeug (10) mittels einer elektronischen Recheneinrichtung (14), bei welchem mittels einer Schalteinrichtung (40) des elektrischen Bordnetzes (12) ein Hochvolt-Energiespeicher (16) des elektrischen Bordnetzes (12) mit einem energiespeicherexternen Teil (30) elektrisch gekoppelt wird, und bei welchem mittels eines ersten Isolationswächters (20) in einem energiespeicherinternen Teil (18) des elektrischen Bordnetzes (12) ein erster Isolationswiderstand (42) in Abhängigkeit eines herangezogenen Kapazitätswerts (48) als Eingabeparameter des elektrischen Bordnetzes (12) bestimmt wird, wobei der erste Isolationswächter (20) des energiespeicherinternen Teils (18) des elektrischen Bordnetzes (12) so ausgelegt ist, dass zur Bestimmung des Isolationswiderstand (42) der Kapazitätswert (48) des elektrischen Bordnetzes (12) als Eingabeparameter herangezogen wird,
**dadurch gekennzeichnet, dass**
mittels zumindest eines zentralen zweiten Isolationswächters (28) des energiespeicherexternen Teils (30) ein zweiter Isolationswiderstand (44) des elektrischen Bordnetzes (12) bestimmt wird,
wobei der zweite Isolationswächter (28) des energiespeicherexternen Teils (30) des elektrischen Bordnetzes (12) so ausgelegt ist, dass zur Bestimmung des Isolationswiderstand (44) kein Kapazitätswert als Eingabeparameter benötigt wird und der Isolationswiderstand (44) daher unabhängig von einem solchen Parameter bestimmt werden kann,
und der erste Isolationswiderstand (42) mit dem zweiten Isolationswiderstand (44) mittels der elektronischen Recheneinrichtung (14) des elektrischen Bordnetzes (12) verglichen wird und in Abhängigkeit von dem Vergleich der herangezogenen Kapazitätswert (48) als Eingabeparameter zum Bestimmen des ersten Isolationswiderstands (42) des elektrischen Bordnetzes (12) mittels des ersten Isolationswächters (20) derart angepasst beziehungsweise variiert wird, dass sich der erste Isolationswiderstand (42) dem zweiten Isolationswiderstand (44) angleicht und
wenn sich nach der Variation des herangezogenen Kapazitätswert (48) als Eingabeparameter der erste Isolationswiderstand (42) und der zweite Isolationswiderstand (44) gleichen, davon ausgegangen werden kann, dass der herangezogenen Kapazitätswert (48) dem aktuellen Kapazitätswert (38) entspricht.

2. Verfahren nach Anspruch 1,
**dadurch gekennzeichnet, dass**
ein Start-Kapazitätswert für den herangezogenen Kapazitätswert (48) als abgespeicherter Kapazitätswert in einer Speichereinrichtung (46) der elektronischen Recheneinrichtung (14) vorgegeben wird.

3. Verfahren nach Anspruch 2,
**dadurch gekennzeichnet, dass**
der Start-Kapazitätswert bei einer Herstellung des Kraftfahrzeugs (10) vorgegeben wird.

4. Verfahren nach einem der vorhergehenden Ansprüche,
**dadurch gekennzeichnet, dass**
zyklisch der erste Isolationswiderstand (42) mit dem zweiten Isolationswiderstand (44) verglichen und eine Anpassung des herangezogenen Kapazitätswerts (48) durchgeführt wird, wobei der herangezogenen Kapazitätswert (48), bei dem der erste Isolationswiderstand (42) dem zweiten Isolationswiderstand (44) am nächsten kommt, als der aktuelle Kapazitätswert (38) übernommen wird.

5. Verfahren nach Anspruch 4,
**dadurch gekennzeichnet, dass**
zum Bestimmen des aktuellen Kapazitätswerts (38) die Anpassung des herangezogenen Kapazitätswerts (48) iterativ erfolgt.

6. Verfahren nach einem der Ansprüche 4 oder 5,
**dadurch gekennzeichnet, dass**
der aktuelle Kapazitätswert (38) als Start-Kapazitätswert für eine zukünftige Auswertung in einer Speichereinrichtung (46) der elektronischen Recheneinrichtung (14) abgespeichert wird.

7. Verfahren nach Anspruch 6,
**dadurch gekennzeichnet, dass**
nach einer Anpassung des aktuellen Kapazitätswerts (38) und Speicherung als Start-Kapazitätswert eine weitere erneute Bestimmung des aktuellen Kapazitätswerts (38) durchgeführt wird und der neu-bestimmte Wert mit dem abgespeicherten Start-Kapazitätswert verglichen wird.

8. Verfahren nach einem der vorhergehenden Ansprüche,
**dadurch gekennzeichnet, dass**
in Abhängigkeit von dem bestimmten aktuellen Kapazitätswert (38) der aktuelle erste Isolationswiderstand (42) des elektrischen Bordnetzes (12) mittels des ersten Isolationswächters (20) bestimmt wird.

9. Elektrisches Bordnetz (12) für ein zumindest teilweise elektrisch betriebenes Kraftfahrzeug (10), mit zumindest einer elektronischen Recheneinrichtung (14), mit einem elektrischen Hochvolt-Energiespeicher (16), mit einem ersten Isolationswächter (20) und mit einem zweiten Isolationswächter (28), wobei das elektrische Bordnetz (12) zum Durchführen eines Verfahrens nach einem der Ansprüche 1 bis 8 ausgebildet ist.

## Claims

1. Method for determining, by means of an electronic computing device (14), at least one current capacitance value (38) of a Y-capacitance (34, 36) of an electrical on-board network (12) for an at least partially electrically operated motor vehicle (10), in which a high-voltage energy storage unit (16) of the electrical on-board network (12) is electrically coupled to a part (30), that is external to the energy storage unit, by means of a switching device (40) of the electrical on-board network (12), and in which a first insulation resistance (42) is determined by means of a first insulation monitor (20) in a part (18), that is internal to the energy storage unit, of the electrical on-board network (12), depending on a capacitance value (48) used as an input parameter of the electrical on-board network (12),
the first insulation monitor (20) of the part (18), that is internal to the energy storage unit, of the electrical on-board network (12) being designed such that the capacitance value (48) of the electrical on-board network (12) is used as the input parameter in order to determine the insulation resistance (42),
**characterized in that**
a second insulation resistance (44) of the electrical on-board network (12) is determined by means of at least one central second insulation monitor (28) of the part (30) that is external to the energy storage unit,
the second insulation monitor (28) of the part (30), that is external to the energy storage unit, of the electrical on-board network (12) being designed such that no capacitance value is required as an input parameter in order to determine the insulation resistance (44), and it therefore being possible to determine the insulation resistance (44) independently of such a parameter,
and the first insulation resistance (42) is compared with the second insulation resistance (44) by means of the electronic computing device (14) of the electrical on-board network (12) and, depending on the comparison, the capacitance value (48) used as the input parameter for determining the first insulation resistance (42) of the electrical on-board network (12) is adjusted or varied by means of the first insulation monitor (20) such that the first insulation resistance (42) aligns with the second insulation resistance (44), and
if, after the variation of the capacitance value (48) used as the input parameter, the first insulation resistance (42) and the second insulation resistance (44) are equal, it can be assumed that the capacitance value (48) used corresponds to the current capacitance value (38).

2. Method according to claim 1,
**characterized in that**
a starting capacitance value for the capacitance value (48) used is specified as a stored capacitance value in a storage device (46) of the electronic computing device (14).

3. Method according to claim 2,
**characterized in that**
the starting capacitance value is specified during production of the motor vehicle (10).

4. Method according to any of the preceding claims,
**characterized in that**
the first insulation resistance (42) is compared with the second insulation resistance (44) cyclically, and the capacitance value (48) used is adjusted, the capacitance value (48) used, in which the first insulation resistance (42) is closest to the second insulation resistance (44), being adopted as the current capacitance value (38).

5. Method according to claim 4,
**characterized in that**
in order to determine the current capacitance value (38), the capacitance value (48) used is adjusted iteratively.

6. Method according to either claim 4 or claim 5,
**characterized in that**
the current capacitance value (38) is stored as the starting capacitance value for a future evaluation in a storage device (46) of the electronic computing device (14).

7. Method according to claim 6,
**characterized in that**
after adjusting the current capacitance value (38) and storing it as the starting capacitance value, an additional determination of the current capacitance value (38) is carried out, and the newly determined value is compared with the stored starting capacitance value.

8. Method according to any of the preceding claims,
**characterized in that**
depending on the determined current capacitance value (38), the current first insulation resistance (42) of the electrical on-board network (12) is determined by means of the first insulation monitor (20).

9. Electrical on-board network (12) for an at least partially electrically operated motor vehicle (10), comprising at least one electronic computing device (14), an electrical high-voltage energy storage unit (16), a first insulation monitor (20) and a second insulation monitor (28), wherein the electrical on-board network (12) is designed to carry out a method according to any of claims 1 to 8.

## Revendications

1. Procédé de détermination d'au moins une valeur de capacité de l'instant (38) d'une capacité Y (34, 36) d'un système électrique embarqué (12) pour un véhicule automobile (10) exploité au moins partiellement à l'électricité, par le biais d'un dispositif électronique de calcul (14), dans lequel, par le biais d'un dispositif de commutation (40) du système électrique embarqué (12), un dispositif de stockage d'énergie haute tension (16) du système électrique embarqué (12) est couplé électriquement à une partie (30) externe au dispositif de stockage d'énergie, et dans lequel, par le biais d'un premier dispositif de surveillance d'isolation (20) dans une partie (18) interne au dispositif de stockage d'énergie du système électrique embarqué (12), une première résistance d'isolation (42) est déterminée en fonction d'une valeur de capacité (48) utilisée comme paramètre d'entrée du système électrique embarqué (12),
dans lequel le premier dispositif de surveillance d'isolation (20) de la partie (18) interne au dispositif de stockage d'énergie du système électrique embarqué (12) est conçu de telle sorte que, pour déterminer la résistance d'isolation (42), la valeur de capacité (48) du système électrique embarqué (12) est utilisée comme paramètre d'entrée,
**caractérisé en ce que**
une seconde résistance d'isolation (44) du système électrique embarqué (12) est déterminée au moyen d'au moins un second dispositif de surveillance d'isolation (28) central de la partie (30) externe au dispositif de stockage d'énergie,
dans lequel le second dispositif de surveillance d'isolation (28) de la partie (30) externe au dispositif de stockage d'énergie du système électrique embarqué (12) est conçu de telle sorte qu'aucune valeur de capacité n'est nécessaire comme paramètre d'entrée pour déterminer la résistance d'isolation (44) et la résistance d'isolation (44) peut donc être déterminée indépendamment d'un tel paramètre,
et la première résistance d'isolation (42) est comparée à la seconde résistance d'isolation (44) par le biais du dispositif électronique de calcul (14) du système électrique embarqué (12) et, en fonction de la comparaison, la valeur de capacité (48) utilisée est adaptée ou modifiée comme paramètre d'entrée pour déterminer la première résistance d'isolation (42) du système électrique embarqué (12) par le biais du premier dispositif de surveillance d'isolation (20) de telle sorte que la première résistance d'isolation (42) corresponde à la seconde résistance d'isolation (44), et
si, après la variation de la valeur de capacité (48) utilisée comme paramètre d'entrée, la première résistance d'isolation (42) et la seconde résistance d'isolation (44) correspondent, on peut supposer que la valeur de capacité (48) utilisée coïncide avec la valeur de capacité de l'instant (38).

2. Procédé selon la revendication 1,
**caractérisé en ce que**
une valeur de capacité de départ pour la valeur de capacité (48) utilisée est prédéfinie comme valeur de capacité mémorisée dans un dispositif de mémoire (46) du dispositif électronique de calcul (14).

3. Procédé selon la revendication 2,
**caractérisé en ce que**
la valeur de capacité de départ est prédéfinie lors d'une fabrication du véhicule automobile (10).

4. Procédé selon l'une des revendications précédentes,
**caractérisé en ce que**
cycliquement, la première résistance d'isolation (42) est comparée à la seconde résistance d'isolation (44) et une adaptation de la valeur de capacité (48) utilisée est réalisée, dans lequel la valeur de capacité (48) utilisée, pour laquelle la première résistance d'isolation (42) est la plus proche de la seconde résistance d'isolation (44), est prise comme valeur de capacité de l'instant (38).

5. Procédé selon la revendication 4,
**caractérisé en ce que**
pour déterminer la valeur de capacité de l'instant (38), l'adaptation de la valeur de capacité (48) utilisée s'effectue de manière itérative.

6. Procédé selon l'une des revendications 4 ou 5,
**caractérisé en ce que**
la valeur de capacité de l'instant (38) est mémorisée comme valeur de capacité de départ pour une évaluation future dans un dispositif de mémoire (46) du dispositif électronique de calcul (14).

7. Procédé selon la revendication 6,
**caractérisé en ce que**
après une adaptation de la valeur de capacité de l'instant (38) et une mémorisation en tant que valeur de capacité de départ, une nouvelle détermination supplémentaire de la valeur de capacité de l'instant (38) est réalisée et la valeur nouvellement déterminée est comparée à la valeur de capacité de départ mémorisée.

8. Procédé selon l'une des revendications précédentes,
**caractérisé en ce que**
en fonction de la valeur de capacité de l'instant (38) déterminée, la première résistance d'isolation de l'instant (42) du système électrique embarqué (12) est déterminée par le biais du premier dispositif de surveillance d'isolation (20).

9. Système électrique embarqué (12) pour un véhicule automobile (10) exploité au moins partiellement à l'électricité, comportant au moins un dispositif électronique de calcul (14), comportant un dispositif de stockage d'énergie haute tension électrique (16), comportant un premier dispositif de surveillance d'isolation (20) et comportant un second dispositif de surveillance d'isolation (28), dans lequel le système électrique embarqué (12) est configuré pour réaliser un procédé selon l'une des revendications 1 à 8.
